(19) Europäisches Patentamt

European Patent Office

Office européen des brevets

(11) **EP 1 925 647 A2**

(12) **EUROPEAN PATENT APPLICATION**

(43) Date of publication:
**28.05.2008 Bulletin 2008/22**

(51) Int Cl.:
***C09G 1/02*** *(2006.01)* ***C09K 3/14*** *(2006.01)*
***H01L 21/304*** *(2006.01)*

(21) Application number: **07254537.9**

(22) Date of filing: **21.11.2007**

(84) Designated Contracting States:
**AT BE BG CH CY CZ DE DK EE ES FI FR GB GR
HU IE IS IT LI LT LU LV MC MT NL PL PT RO SE
SI SK TR**
Designated Extension States:
**AL BA HR MK RS**

(30) Priority: **24.11.2006 JP 2006317380**

(71) Applicant: **FUJIMI INCORPORATED
Aichi (JP)**

(72) Inventors:
• **Shimizu, Mikikazu, Fujimi Incorporated
Kiyosu-shi, Aichi (JP)**
• **Nakajima, Takehiko, Fujimi Incorporated
Kiyosu-shi, Aichi (JP)**
• **Ito, Takashi, Fujimi Incorporated
Kiyosu-shi, Aichi (JP)**
• **Hiramitsu, Ai, Fujimi Incorporated
Kiyosu-shi, Aichi (JP)**

(74) Representative: **Paget, Hugh Charles Edward et al
Mewburn Ellis LLP
York House
23 Kingsway
London WC2B 6HP (GB)**

(54) **Polishing composition and polishing method**

(57)    To provide a polishing composition which is capable of selectively polishing a silicon oxide film against a polysilicon film, and a polishing method employing such a polishing composition.

The polishing composition of the present invention comprises abrasive grains selected from silica and ceria; an alkali selected from ammonia, an ammonium salt, an alkali metal salt and an alkali metal hydroxide; and an organic modified silicone oil selected from a polyoxyethylene-modified silicone oil, a poly(oxyethyleneoxypropylene)-modified silicone oil, an epoxy/polyether-modified silicone oil and an amino/polyether-modified silicone oil.

Printed by Jouve, 75001 PARIS (FR)

**Description**

The present invention relates to a polishing composition which may be used mainly for an application to polish a silicon oxide film, particularly for an application to polish a silicon oxide film formed on a polysilicon film, and a polishing method employing such a polishing composition.

In STI (Shallow Trench Isolation) as one type of semiconductor element isolation technique, a silicon oxide film formed on a silicon substrate is planarized by CMP (Chemical Mechanical Polishing). A CMP slurry for such STI is naturally desired to have a high stock removal rate of a silicon oxide film, but in addition, is desired to have a low stock removal rate of a polysilicon film to prevent e.g. a polysilicon film formed in an element region removed by CMP. Namely, it is desired that a silicon oxide film can be selectively polished against a polysilicon film.

The following Patent Documents 1 and 2 may be mentioned as prior art references relating to the present invention.

Patent Document 1: WO00/39843

Patent Document 2: JP-A-2001-501369

The present invention has been made under such circumstances, and it is an object of the present invention to provide a polishing composition which is capable of selectively polishing a silicon oxide film against a polysilicon film, and a polishing method employing such a polishing composition.

To accomplish the above object, the present invention provides the following.

1. A polishing composition comprising abrasive grains selected from silica and ceria; an alkali selected from ammonia, an ammonium salt, an alkali metal salt and an alkali metal hydroxide; and an organic modified silicone oil selected from a polyoxyethylene-modified silicone oil, a poly(oxyethyleneoxypropylene)-modified silicone oil, an epoxy/polyether-modified silicone oil and an amino/polyether-modified silicone oil.

2. The polishing composition according to the above 1, wherein the abrasive grains are silica.

3. A polishing method which comprises polishing a silicon oxide film formed on a polysilicon film by means of the polishing composition as defined in the above 1 or 2.

4. A polishing method which comprises polishing a silicon oxide film formed on a polysilicon film by means of the polishing composition as defined in the above 2.

According to the present invention, a polishing composition which is capable of selectively polishing a silicon oxide film against a polysilicon film, and a polishing method employing such a polishing composition, are presented.

Now, an embodiment of the present invention will be described.

The polishing composition of this embodiment is produced by mixing abrasive grains, an alkali and an organic modified silicone oil to water. Accordingly, the polishing composition comprises abrasive grains, an alkali and an organic modified silicone oil, and water. Such a polishing composition is used for an application to polish a silicon oxide film, particularly for an application to polish a silicon oxide film formed on a polysilicon film.

The above abrasive grains have a function to mechanically polish the silicon oxide film and serves to improve the stock removal rate of the silicon oxide film by the polishing composition.

The abrasive grains contained in the polishing composition are selected from silica and ceria, and they are preferably silica, more preferably fumed silica or colloidal silica, further preferably fumed silica. In a case where the abrasive grains contained in the polishing composition are silica, the dispersibility of the abrasive grains in an alkali region can be improved. Further, in the case of fumed silica or colloidal silica, defects on the surface after polishing by the polishing composition can be reduced, and in the case of fumed silica, further, the stock removal rate of the silicon oxide film by the polishing composition can be improved particularly substantially.

The content of the abrasive grains in the polishing composition is preferably at least 4 mass% in a case where the abrasive grains are silica and preferably at least 0.1 mass% in a case where the abrasive grains are ceria. As the content of the abrasive grains increases, the stock removal rate of the silicon oxide film by the polishing composition tends to be improved. In this respect, it is possible to improve the stock removal rate of the silicon oxide film by the polishing composition to a practically particularly suitable level, when the content of silica in the polishing composition is at least 4 mass% or when the content of ceria in the polishing composition is at least 0.1 mass%.

The content of the abrasive grains in the polishing composition is preferably at most 25 mass% in a case where the abrasive grains are silica, and preferably at most 10 mass% in a case where the abrasive grains are ceria. As the content of the abrasive grains decreases, the dispersibility of the abrasive grains will be improved, and sedimentation in the polishing composition tends to be less likely to occur. In this respect, it is possible to improve the dispersibility of the abrasive grains in the polishing composition to a practically particularly suitable level, when the content of silica in the polishing composition is at most 25 mass% or the content of ceria in the polishing composition is at most 10 mass%.

The average particle size of the abrasive grains contained in the polishing composition is preferably at least 20 nm, more preferably at least 25 nm, in either case where the abrasive grains are silica or ceria. As the average particle size of the abrasive grains increases, the function of the abrasive grains to mechanically polish the silicon oxide film tends to be strong, whereby the stock removal rate of the silicon oxide film by the polishing composition will be improved. In this respect, it is possible to improve the stock removal rate of the silicon oxide film by the polishing composition to a practically particularly suitable level, when the average particle size of the abrasive grains is at least 20 nm, more preferably at least 25 nm.

The average particle size of the abrasive grains contained in the polishing composition is preferably at most 100 nm, more preferably at most 75 nm in a case where the abrasive grains are silica, and is preferably at most 200 nm, more preferably at most 100 nm, in a case where the abrasive grains are ceria. As the average particle size of the abrasive grains decreases, the dispersibility of the abrasive grains will be improved, and sedimentation in the polishing composition tends to be less likely to occur. In this respect, it is possible to improve the dispersibility of the abrasive grains in the polishing composition to a practically particularly suitable level, when the average particle size of silica is at most 100 nm, more preferably at most 75 nm. Further, likewise, it is possible to improve the dispersibility of the abrasive grains in the polishing composition to a practically particularly suitable level, when the average particle diameter of ceria is at most 200 nm, more preferably at most 100 nm. Here, the value of the above average particle size is one calculated based on the specific surface area of the abrasive grains measured by a BET method and the density of the abrasive grain particles.

The above-mentioned alkali has a function to chemically polish a silicon oxide film and serves to improve the stock removal rate of a silicon oxide film by the polishing composition.

The alkali contained in the polishing composition is selected from ammonia, an ammonium salt, an alkali metal salt and an alkali metal hydroxide, and preferred is an alkali metal hydroxide. In a case where the alkali contained in the polishing composition is an alkali metal hydroxide, it is possible to particularly substantially improve the stock removal rate of a silicon oxide film by the polishing composition. The ammonium salt may, for example, be ammonium carbonate, and the alkali metal salt may, for example, be potassium carbonate, sodium carbonate or lithium carbonate. The alkali metal hydroxide may, for example, be potassium hydroxide, sodium hydroxide or lithium hydroxide. Here, if the alkali contained in the polishing composition is a compound other than ammonia, an ammonium salt, an alkali metal salt and an alkali metal hydroxide, such as tetramethylammonium hydroxide (TMAH), the stock removal rate of a silicon oxide film by the polishing composition will not be improved so much.

The content of the alkali in the polishing composition is preferably at least 0.01 mass%, more preferably at least 0.1 mass%. As the content of the alkali increases, the stock removal rate of a silicon oxide film by the polishing composition tends to be improved. In this respect, it is possible to improve the stock removal rate of a silicon oxide film by the polishing composition to a practically particularly suitable level, when the content of the alkali in the polishing composition is at least 0.01 mass%, more preferably at least 0.1 mass%.

The content of the alkali in the polishing composition is preferably at most 10 mass%, more preferably at most 2 mass%. As the content of the alkali decreases, the stability of the abrasive grains in the polishing composition will be improved. In this respect, it is possible to improve the stability of the abrasive grains in the polishing composition to a practically particularly suitable level, when the content of the alkali in the polishing composition is at most 10 mass%, more preferably at most 2 mass%.

The above-mentioned organic modified silicone oil serves to suppress polishing of a polysilicon film by the polishing composition. This is believed to be mainly such that the organic modified silicone oil forms a protective film on the surface of a polysilicon film, and this protective film will suppress etching of the polysilicon film by the alkali in the polishing composition.

The organic modified silicone oil contained in the polishing composition is selected from a polyoxyethylene-modified silicone oil, a poly(oxyethyleneoxypropylene)-modified silicone oil, an epoxy/polyether-modified silicone oil and an amino/polyether-modified silicone oil. Namely, the organic modified silicone oil is one having part of methyl groups of a polysiloxane, more specifically, methyl groups at both terminals or one terminal of a polysiloxane, or a methyl group at a part of a side chain, or methyl groups at a part of a side chain and at both terminals or one terminal, are substituted by a polyoxyethylene group or a poly(oxyethyleneoxypropylene) group, or an epoxy group and a polyether group, or an amino group and a polyether group.

The content of the organic modified silicone oil in the polishing composition is preferably at least 0.005 mass%, more preferably at least 0.01 mass%. As the content of the organic modified silicone oil increases, polishing of a polysilicon film by the polishing composition will be suppressed more strongly. In this respect, it is possible to reduce the stock removal rate of a polysilicon film by the polishing composition to a practically particularly suitable level, when the content of the organic modified silicone oil in the polishing composition is at least 0.005 mass%, more preferably at least 0.01 mass%.

The content of the organic modified silicone oil in the polishing composition is preferably at most 10 mass%, more preferably at most 5 mass%, further preferably at most 3 mass%. As the content of the organic modified silicone oil decreases, the stock removal rate of a silicon oxide film by the polishing composition will be improved. In this respect, it is possible to improve the stock removal rate of a silicon oxide film by the polishing composition to a practically particularly suitable level, when the content of the organic modified silicone oil in the polishing composition is at most 10 mass%, preferably at most 5 mass%, more preferably at most 3 mass%.

The HLB (hydrophile-lipophile balance) value of the organic modified silicone oil contained in the polishing composition is preferably at least 2, more preferably at least 6, further preferably at least 7. As the HLB value of the organic modified silicone oil increases, an organic residue remaining as a foreign matter on the surface after polishing by the polishing composition will be reduced. In this respect, it is possible to reduce the organic residue remaining on the surface after polishing by the polishing composition to a practically particularly suitable level, when the HLB value of the organic modified silicone oil is at least 2, preferably at least 6, more preferably at least 7.

The HLB value of the organic modified silicone oil contained in the polishing composition is preferably at most 15, more preferably at most 12. As the HLB value of the organic modified silicone oil decreases, polishing of a polysilicon film by the polishing composition can be suppressed more strongly. In this respect, it is possible to lower the stock removal rate of a polysilicon film by the polishing composition to a practically particularly suitable level, when the HLB value of the organic modified silicone oil is at most 15, more preferably at most 12.

The average molecular weight of the organic modified silicone oil contained in the polishing composition is preferably from 200 to 20,000, more preferably from 200 to 10,000. The organic modified silicone oil having an average molecular weight of from 200 to 20,000, more preferably from 200 to 10,000, is capable of suppressing polishing of a polysilicon film by the polishing composition particularly effectively.

The following merits are obtainable by this embodiment.

The polishing composition of this embodiment comprises prescribed abrasive grains, a prescribed alkali and a prescribed organic modified silicone oil, whereby the stock removal rate of a silicon oxide film is high, while the stock removal rate of a polysilicon film is low. Thus, by this polishing composition, a silicon oxide film can selectively be polished against a polysilicon film. Accordingly, this polishing composition is suitable for an application to polish a silicon oxide film, particularly for an application to polish a silicon oxide film formed on a polysilicon film.

The above embodiment may be modified as follows.

The polishing composition of the above embodiment may be used for an application to polish an object to be polished other than a silicon oxide film. Specifically, it may be used for an application to polish a silicon nitride film, particularly for an application to polish a silicon nitride film formed on a polysilicon film. However, in this case, the abrasive grains are preferably silica i.e. not ceria. Silica has a function to mechanically polish a silicon nitride film in addition to a function to mechanically polish a silicon oxide film. Therefore, by a polishing composition wherein the abrasive grains are silica, it is possible to selectively polish a silicon nitride film against a polysilicon film. Accordingly, a polishing composition wherein the abrasive grains are silica, is suitable also for an application to polish a silicon nitride film, particularly for an application to polish a silicon nitride film formed on a polysilicon film.

The polishing composition of the above embodiment may be used also for an application to polish a silicon oxide film or a silicon nitride film formed on a base material other than a polysilicon film. Such a base material may, for example, be a silicon substrate. Specifically, it may be used for an application to polish a silicon oxide film or a silicon nitride film formed on a silicon substrate or on a polysilicon film formed on a silicon substrate.

To the polishing composition of the above embodiment, at least two types of abrasive grains may be incorporated.

To the polishing composition of the above embodiment, at least two types of alkalis may be incorporated.

To the polishing composition of the above embodiment, at least two types of organic modified silicone oils may be incorporated.

To the polishing composition of the above embodiment, an anti-fungal agent, an anti-corrosion agent, a defoaming agent, a chelating agent, etc. may be added, as the case requires.

The polishing composition of the above embodiment may be prepared by diluting a stock solution of the polishing composition with water.

Now, Examples and Comparative Examples of the present invention will be described.

EXAMPLES 1 to 40 and COMPARATIVE EXAMPLES 1 to 18

Polishing compositions of Examples 1 to 40 were prepared by suitably mixing abrasive grains, an alkali and an organic modified silicone oil with water. Polishing compositions of Comparative Examples 1 to 18 were prepared by suitably mixing abrasive grains, an alkali or an acid, and an organic modified silicone oil or a compound as a substitute therefor, with water. The details of the abrasive grains, the alkali or acid, and the organic modified silicone oil or a compound as a substitute thereof, in the polishing composition of each Example are as shown in Table 1.

In the column for "stock removal rate" in Tables 1 and 2, the results of measurements of the stock removal rate of a silicon oxide film, the stock removal rate of a silicon nitride film and the stock removal rate of a polysilicon film, are shown when a silicon oxide film (TEOS film)-coated wafer, a silicon nitride film-coated wafer and a polysilicon film-coated wafer were polished under the polishing conditions shown in Table 3 by means of the respective polishing compositions of Examples 1 to 40 and Comparative Examples 1 to 18. The stock removal rate was obtained by dividing the difference in thickness of each wafer as between before and after polishing by the polishing time. For the measurement of the thickness of the wafer, a thin film-measuring apparatus "VM2030", manufactured by DAINIPPON SCREEN MFG. CO., LTD. was used.

In the column for "selectivity" in Tables 1 and 2, the results obtained by calculating the ratio ($SiO_2$/Poly-Si) of the stock removal rate of a silicon oxide film to the stock removal rate of a polysilicon film and the ratio ($Si_3N_4$/Poly-Si) of the stock removal rate of a silicon nitride film to the stock removal rate of a polysilicon film, from the stock removal rates of a silicon oxide film, a silicon nitride film and a polysilicon film obtainable as described above, are shown.

TABLE 1

| | Abrasive grains | | Alkali or acid | | Organic modified silicone oil or compound as a substitute therefor | | Stock removal rate | | | Selectivity | |
|---|---|---|---|---|---|---|---|---|---|---|---|
| | Type | Content (mass%) | Type | Content (mass% | Type | Content (mass%) | $SiO_2$ (Å/min) | $Si_3N_4$ (Å/min) | Poly-Si (Å/min) | $SiO_2$/ Poly-Si | $Si_3N_4$/ Poly-Si |
| Comparative Example 1 | Fumed silica | 12.5 | KOH | 0.49 | - | 0 | 2118 | 1080 | 4264 | 0.5 | 0.3 |
| Example 1 | Fumed silica | 12.5 | KOH | 0.49 | A1 | 0.25 | 1419 | 695 | 59 | 24.1 | 11.8 |
| Example 2 | Fumed silica | 12.5 | KOH | 0.49 | A2 | 0.25 | 1273 | 624 | 72 | 17.7 | 8.7 |
| Example 3 | Fumed silica | 12.5 | KOH | 0.49 | A3 | 0.25 | 1368 | 670 | 60 | 22.8 | 11.2 |
| Example 4 | Fumed silica | 12.5 | KOH | 0.49 | A4 | 0.25 | 2340 | 1240 | 110 | 21.3 | 11.3 |
| Example 5 | Fumed silica | 12.5 | KOH | 0.49 | A5 | 0.25 | 1349 | 661 | 47 | 28.7 | 14.1 |
| Example 6 | Fumed silica | 12.5 | KOH | 0.49 | A6 | 0.25 | 1880 | 846 | 96 | 19.6 | 8.8 |
| Example 7 | Fumed silica | 12.5 | KOH | 0.49 | A7 | 0.25 | 1877 | 995 | 99 | 18.9 | 10.0 |
| Example 8 | Fumed silica | 12.5 | KOH | 0.49 | A8 | 0.25 | 1673 | 820 | 92 | 18.2 | 8.9 |
| Example 9 | Fumed silica | 12.5 | KOH | 0.49 | A9 | 0.25 | 1789 | 877 | 92 | 19.4 | 9.5 |
| Example 10 | Fumed silica | 12.5 | KOH | 0.49 | A10 | 0.25 | 1147 | 574 | 129 | 8.9 | 4.4 |
| Example 11 | Fumed silica | 12.5 | KOH | 0.49 | A11 | 0.25 | 1955 | 1005 | 96 | 20.4 | 10.5 |
| Example 12 | Fumed silica | 12.5 | KOH | 0.49 | A6 | 0.005 | 2103 | 988 | 343 | 6.1 | 2.9 |

| | Abrasive grains | | Alkali or acid | | Organic modified silicone oil or compound as a substitute therefor | | Stock removal rate | | | Selectivity | |
|---|---|---|---|---|---|---|---|---|---|---|---|
| | Type | Content (mass%) | Type | Content (mass% | Type | Content (mass%) | $SiO_2$ (Å/min) | $Si_3N_4$ (Å/min) | Poly-Si (Å/min) | $SiO_2$/ Poly-Si | $Si_3N_4$/ Poly-Si |
| Example 13 | Fumed silica | 12.5 | KOH | 0.49 | A6 | 0.01 | 2098 | 1007 | 198 | 10.6 | 5.1 |
| Example 14 | Fumed silica | 12.5 | KOH | 0.49 | A6 | 0.05 | 2032 | 914 | 139 | 14.6 | 6.6 |
| Example 15 | Fumed silica | 12.5 | KOH | 0.49 | A6 | 0.1 | 1960 | 882 | 131 | 14.9 | 6.7 |
| Example 16 | Fumed silica | 12.5 | KOH | 0.49 | A6 | 0.5 | 1820 | 965 | 129 | 14.1 | 7.5 |
| Example 17 | Fumed silica | 12.5 | KOH | 0.49 | A7 | 0.005 | 2150 | 1176 | 371 | 5.8 | 3.2 |
| Example 18 | Fumed silica | 12.5 | KOH | 0.49 | A7 | 0.01 | 2201 | 1122 | 261 | 8.4 | 4.3 |
| Example 19 | Fumed silica | 12.5 | KOH | 0.49 | A7 | 0.05 | 2101 | 945 | 123 | 17.1 | 7.7 |
| Example 20 | Fumed silica | 12.5 | KOH | 0.49 | A7 | 0.1 | 2089 | 1107 | 112 | 18.7 | 9.9 |
| Example 21 | Fumed silica | 12.5 | KOH | 0.49 | A7 | 0.5 | 1886 | 849 | 123 | 15.4 | 6.9 |
| Example 22 | Fumed silica | 12.5 | KOH | 0.49 | A7 | 1.0 | 1835 | 972 | 131 | 14.0 | 7.4 |
| Example 23 | Fumed silica | 12.5 | KOH | 0.49 | A7 | 3.0 | 1627 | 781 | 131 | 12.4 | 6.0 |
| Comparative Example 2 | Fumed silica | 12.5 | KOH | 0.49 | B1 | 0.25 | 2051 | 984 | 1063 | 1.9 | 0.9 |
| Comparative Example 3 | Fumed silica | 12.5 | KOH | 0.49 | B2 | 0.25 | 1775 | 799 | 480 | 3.7 | 1.7 |

(continued)

| | Abrasive grains | | Alkali or acid | | Organic modified silicone oil or compound as a substitute therefor | | Stock removal rate | | | Selectivity | |
|---|---|---|---|---|---|---|---|---|---|---|---|
| | Type | Content (mass%) | Type | Content (mass% | Type | Content (mass%) | $SiO_2$ (Å/min) | $Si_3N_4$ (Å/min) | Poly-Si (Å/min) | $SiO_2$/ Poly-Si | $Si_3N_4$/ Poly-Si |
| Comparative Example 4 | Fumed silica | 12.5 | KOH | 0.49 | B3 | 0.25 | 1766 | 936 | 540 | 3.3 | 1.7 |
| Comparative Example 5 | Fumed silica | 12.5 | KOH | 0.49 | B4 | 0.25 | 1743 | 889 | 1375 | 1.3 | 0.6 |
| Comparative Example 6 | Fumed silica | 12.5 | KOH | 0.49 | B5 | 0.25 | 1667 | 750 | 922 | 1.8 | 0.8 |
| Comparative Example 7 | Fumed silica | 12.5 | KOH | 0.49 | B6 | 0.25 | 1743 | 889 | 669 | 2.6 | 1.3 |
| Comparative Example 8 | Fumed silica | 12.5 | KOH | 0.49 | B7 | 0.25 | 1795 | 915 | 986 | 1.8 | 0.9 |
| Comparative Example 9 | Fumed silica | 12.5 | KOH | 0.49 | B8 | 0.25 | 2143 | 1029 | 870 | 2.5 | 1.2 |

TABLE 2

| | Abrasive grains | | Alkali or acid | | Organic modified silicone oil or compound as a substitute therefor | | Stock removal rate | | | Selectivity | |
|---|---|---|---|---|---|---|---|---|---|---|---|
| | Type | Content (mass%) | Type | Content (mass% | Type | Content (mass%) | $SiO_2$ (Å/min) | $Si_3N_4$ (Å/min) | Poly-Si (Å/min) | $SiO_2$/Poly-Si | $Si_3N_4$/Poly-Si |
| Example 24 | Fumed silica | 12.5 | KOH | 0.01 | A7 | 0.25 | 921 | 433 | 155 | 5.9 | 2.8 |
| Example 25 | Fumed silica | 12.5 | KOH | 0.10 | A7 | 0.25 | 1608 | 772 | 185 | 8.7 | 4.2 |
| Example 26 | Fumed silica | 12.5 | KOH | 0.25 | A7 | 0.25 | 1589 | 810 | 74 | 21.5 | 11.0 |
| Example 27 | Fumed silica | 12.5 | KOH | 1.00 | A7 | 0.25 | 2103 | 1072 | 102 | 20.6 | 10.5 |
| Example 28 | Fumed silica | 12.5 | $NH_3$ | 0.10 | A7 | 0.25 | 844 | 380 | 116 | 7.3 | 3.3 |
| Example 29 | Fumed silica | 12.5 | $NH_3$ | 0.25 | A7 | 0.25 | 1103 | 496 | 137 | 8.1 | 3.6 |
| Example 30 | Fumed silica | 12.5 | $NH_3$ | 0.49 | A7 | 0.25 | 1369 | 698 | 155 | 8.8 | 4.5 |
| Example 31 | Fumed silica | 12.5 | $NH_3$ | 1.00 | A7 | 0.25 | 1495 | 718 | 182 | 8.2 | 3.9 |
| Example 32 | Fumed silica | 12.5 | Potassium carbonate | 0.49 | A7 | 0.25 | 1976 | 998 | 96 | 20.6 | 10.4 |
| Example 33 | Fumed silica | 12.5 | Ammonium carbonate | 0.49 | A7 | 0.25 | 1425 | 745 | 119 | 12.0 | 6.3 |
| Comparative Example 10 | Fumed silica | 12.5 | TMAH | 0.49 | A7 | 0.25 | 12 | 23 | 87 | 0.1 | 0.3 |
| Comparative Example 11 | Fumed silica | 12.5 | $(CH_3)_2NH$ | 0.49 | A7 | 0.25 | 43 | 84 | 185 | 0.2 | 0.5 |
| Example 34 | Fumed silica | 2 | KOH | 0.49 | A7 | 0.25 | 357 | 182 | 70 | 5.1 | 2.6 |

| | Abrasive grains | | Alkali or acid | | Organic modified silicone oil or compound as a substitute therefor | | Stock removal rate | | | Selectivity | |
|---|---|---|---|---|---|---|---|---|---|---|---|
| | Type | Content (mass%) | Type | Content (mass% | Type | Content (mass%) | $SiO_2$ (Å/min) | $Si_3N_4$ (Å/min) | Poly-Si (Å/min) | $SiO_2$/Poly-Si | $Si_3N_4$/Poly-Si |
| Example 35 | Fumed silica | 4 | KOH | 0.49 | A7 | 0.25 | 900 | 430 | 110 | 8.2 | 3.9 |
| Example 36 | Fumed silica | 6 | KOH | 0.49 | A7 | 0.25 | 1100 | 495 | 101 | 10.9 | 4.9 |
| Example 37 | Fumed silica | 25 | KOH | 0.49 | A7 | 0.25 | 2468 | 1259 | 161 | 15.3 | 7.8 |
| Example 38 | Fumed silica* | 12.5 | KOH | 0.49 | A7 | 0.25 | 884 | 451 | 51 | 17.2 | 8.8 |
| Example 39 | Colloidal silica | 12.5 | KOH | 0.49 | A7 | 0.25 | 1003 | 532 | 99 | 10.2 | 5.4 |
| Comparative Example 12 | Colloidal silica | 12.5 | Nitric acid | pH3 | A7 | 0.25 | - | - | - | - | - |
| Comparative Example 13 | Colloidal silica | 12.5 | oxalic acid | pH3 | A7 | 0.25 | - | - | - | - | - |
| Comparative Example 14 | Colloidal silica | 12.5 | Adipic acid | pH3 | A7 | 0.25 | - | - | - | - | - |
| Comparative Example 15 | Colloidal silica | 12.5 | Propionic acid | pH3 | A7 | 0.25 | - | - | - | - | - |
| Comparative Example 16 | Fumed silica | 12.5 | Nitric acid | pH2 | A7 | 0.25 | - | - | - | - | - |
| Comparative Example 17 | Fumed silica | 12.5 | Sulfuric acid | pH2 | A7 | 0.25 | - | - | - | - | - |
| Example 40 | Ceria | 3.0 | KOH | 0.49 | A7 | 0.25 | 5538 | 96 | 326 | 17.0 | 0.3 |
| Comparative Example 18 | Alumina | 1.0 | KOH | 0.49 | A7 | 0.25 | 3714 | 130 | 2168 | 1.7 | 0.1 |

In the column for "Abrasive grains" in Tables 1 and 2, "Fumed silica*" represents a fumed silica having an average particle size of 30 nm, "Fumed silica*" represents a fumed silica having an average particle size of 50 nm, "Colloidal silica" represents a colloidal silica having an average particle size of 90 nm, "Ceria" represents ceria having an average particle size of 60 nm, and "Alumina" represents an alumina having an average particle size of 100 nm.

In the column for "Alkali or acid" in Tables 1 and 2, "KOH" represents potassium hydroxide, "NH$_3$" represents ammonia, "TMAH" represents tetramethylammonium hydroxide" and "(CH$_3$)$_2$NH" represents dimethylamine.

In the column for "Organic modified silicone oil or compound as a substitute therefor" in Tables 1 and 2, "A1" represents a side chain type polyoxyethylene-modified silicone oil having a HLB value of 2; "A2" represents a side chain type polyoxyethylene-modified silicone oil having a HLB value of 3; "A3" represents a side chain type polyoxyethylene-modified silicone oil having a HLB value of 5; "A4" represents a side chain type poly(oxyethyleneoxypropylene)-modified silicone coil having a HLB value of 7; "A5" represents a side chain type polyoxyethylene-modified silicone oil having a HLB value of 8; "A6" represents a side chain type polyoxyethylene-modified silicone oil having a HLB value of 10; "A7" represents a side chain type polyoxyethylene-modified silicone oil having a HLB value of 12, "A8" represents a side chain type polyoxyethylene-modified silicone oil having a HLB value of 13; "A9" represents a side chain type epoxy/polyether-modified silicone oil having a HLB value of 11; "A10" represents a side chain type amino/polyether-modified silicone oil having a HLB value of 12; "A11" represents a both terminal type poly(oxyethyleneoxypropylene)-modified silicone oil having a HLB value of 7; "B1" represents a hydroxyethylcellulose having an average molecular weight of 1,200,000; "B2" represents a polyvinyl alcohol having a polymerization degree of 200 and a saponification degree of at least 98%; "B3" represents a polyoxyethylene lauryl ether having a HLB value of 12.9; "B4" represents a polyvinylpyrrolidone having an average molecular weight of 9,000; "B5" represents a polyoxyethylenealkyl phenyl ether phosphoric acid having a HLB value of 9.8; "B6" represents a polyoxyethylenealkyl phenyl ether phosphoric acid having a HLB value of 10.5; "B7" represents a polyoxyethylenealkyl ether phosphoric acid having a HLB value of 10.5; and "B8" represents a polyethylene glycol having an average molecular weight of 2,000.

The HLB value was calculated by the following formula by Griffin's method.

$$HLB=20*Mh/M$$

where Mh is the molecular mass of the hydrophilic portion of the Molecule, and M is the molecular mass of the whole molecule.

TABLE 3

| Polishing machine: Mirra (manufactured by Applied Materials) |
| --- |
| Polishing load: 17.2 kPa (2.5 psi) |
| Plate rotational speed: 90 rpm |
| Polishing time: 60 sec |
| Supply rate of polishing composition: 200 mL/min |

As shown in Tables 1 and 2, by the polishing compositions of Examples 1 to 40, with respect to the stock removal rate of a silicon oxide film, a high numerical value of practically sufficient level was obtained, and also with respect to the selectivity between the polysilicon film and the silicon oxide film, a high numerical value of practically sufficient level was obtained. Among them, by the polishing compositions of Examples 1 to 40 containing silica as abrasive grains, with respect to not only the stock removal rate of a silicon oxide film but also the stock removal rate of a silicon nitride film, a high numerical value of practically sufficient level was obtained, and also with respect to the selectivity between the polysilicon film and the silicon nitride film, a high numerical value of practically sufficient level was obtained.

Whereas, by the polishing compositions of Comparative Examples 1 to 18, a high numerical value of practically sufficient level was not obtained with respect to the stock removal rates of a silicon oxide film and a silicon nitride film, or a low numerical value of practically sufficient level was not obtained with respect to the stock removal rate of a polysilicon film, and a high numerical value of practically sufficient level was not obtained with respect to each of the selectivity between the polysilicon film and the silicon oxide film and the selectivity between the polysilicon film and the silicon nitride film.

The entire disclosure of Japanese Patent Application No. 2006-317380 filed on November 24, 2006 including specification, claims and summary is incorporated herein by reference in its entirety.

**Claims**

1.  A polishing composition comprising abrasive grains selected from silica and ceria; an alkali selected from ammonia, an ammonium salt, an alkali metal salt and an alkali metal hydroxide; and an organic modified silicone oil selected from a polyoxyethylene-modified silicone oil, a poly(oxyethyleneoxypropylene)-modified silicone oil, an epoxy/polyether-modified silicone oil and an amino/polyether-modified silicone oil.

2.  The polishing composition according to Claim 1, wherein the abrasive grains are silica.

3.  A polishing method which comprises polishing a silicon oxide film formed on a polysilicon film by means of the polishing composition as defined in Claim 1 or 2.

4.  A polishing method which comprises polishing a silicon oxide film formed on a polysilicon film by means of the polishing composition as defined in Claim 2.

**REFERENCES CITED IN THE DESCRIPTION**

**Patent documents cited in the description**

- WO 0039843 A
- JP 2001501369 A
- JP 2006317380 A